# EUROPÄISCHE PATENTSCHRIFT

(11) **EP 1 034 692 B1**
(45) Veröffentlichungstag und Bekanntmachung des Hinweises auf die Patenterteilung: **04.07.2001**
(21) Anmeldenummer: 98949916.5
(22) Anmeldetag: 19.08.1998
(51) Int. Cl.: H05K 5/02

(54) **BELÜFTUNGSEINRICHTUNG, INSBESONDERE FÜR ELEKTRISCHE STEUERGERÄTE**
VENTILATION DEVICE, ESPECIALLY FOR ELECTRICAL CONTROL DEVICES
DISPOSITIF DE VENTILATION, NOTAMMENT POUR APPAREILS DE COMMANDE ELECTRIQUES

(30) Priorität: 28.11.1997 DE 19752966
(43) Veröffentlichungstag der Anmeldung: 13.09.2000
(73) Patentinhaber: SIEMENS AKTIENGESELLSCHAFT, 80333 München (DE)
(72) Erfinder: BORISCH, Wolfgang, D-93077 Bad Abbach (DE)
(86) Internationale Anmeldenummer: DE9802415
(87) Internationale Veröffentlichungsnummer: WO9929150

(56) Entgegenhaltungen:
- EP-A- 0 377 067
- EP-A- 0 756 966
- DE-A- 3 716 912
- US-A- 4 639 818

## Beschreibung

Die Erfindung betrifft eine Belüftungseinrichtung gemäß dem Oberbegriff des Anspruchs 1.

Derartige Belüftungseinrichtungen, vgl. z.B. EP-A-0377067, dienen der Be- und Entlüftung von Gehäuseinnenräumen von elektrischen Steuergeräten, insbesondere im Kraftfahrzeugbereich.

Eine Belüftungseinrichtung ist aus DE 91 15 939 U bekannt. Hierbei weist eine Belüftungseinrichtung einen Stutzen auf, der in einer Aufnahmeöffnung einer Wand eines Gehäuses eines elektrischen Geräts durch Reibverschweißung stoffschlüssig mit dem Gehäuse verbunden ist. In dem Stutzen wird ein Druckausgleichselement, das aus einer Trägerscheibe, einer Deckscheibe und einer zwischen den Scheiben befindlichen Membran besteht und durch Ultraschallverschweißung einstückig zusammengefügt ist, durch Reibverschweißung fixiert. Das Druckausgleichselement wird durch einen auf dem Stutzen angebrachten Deckel insbesondere vor mechanischen Beschädigungen geschützt. Der Deckel weist Öffnungen auf, durch die ein Gas zum Membranbereich strömen kann. Die Belüftungseinrichtung ist kompliziert im Aufbau und aufwendig herzustellen.

Gemäß WO 96/03629 ist eine Belüftungseinrichtung mit einer Schutzmembran für einen Siliziumdrucksensor bekannt. Hierbei sind oberhalb eines zu schützenden und zu belüftenden Siliziumchips ein Hohlraum und eine Membran vorgesehen. Letzere wird durch eine ringförmige Abdeckung fixiert, welche insbesondere zur Kompensation von Temperaturschwankungen federnd ausgebildet ist. Auch diese Belüftungseinrichtung ist in ihrem Aufbau kompliziert und in der Herstellung teuer.

Der Erfindung liegt daher die Aufgabe zugrunde, eine Belüftungseinrichtung zu schaffen, die einfach und kostengünstig herstellbar ist.

Diese Aufgabe wird erfindungsgemäß durch die Merkmale des kennzeichnenden Teils des Anspruchs 1 gelöst.

Die erfindungsgemäße Lösung weist den Vorteil auf, daß Spritzwasser, das von außen an das Gehäuse geführt wird, höchstens die Kanalaußenöffnung, jedoch in der Regel nicht die Innenöffnung durchdringen kann, da beide Öffnungen nicht fluchtend angeordnet sind und somit Wasser erst die Belüftungskanaleinheit durchdringen muß, welche, da in er Gehäusewandung angeordnet, im wesentlichen senkrecht zur auftreffenden Richtung von Spritzwasser verläuft.

In den abhängigen Ansprüchen 2 bis 9 sind weitere vorteilhafte Weiterbildungen der Erfindung offenbart.

Besonders vorteilhaft ist, daß Typenschilder, die ohnehin auf Elektrogeräten angebracht werden, gleichzeitig eine Wand der Belüftungskanaleinheit bilden. Membranen können einfach eingesetzt und ausgewechselt werden, da sie lediglich in eine Vertiefung eingeklebt werden, was vor Anbringen des Typenschilds problemlos ist.

Vorteilhafterweise kann die Belüftungskanaleinheit so ausgebildet werden, daß die Kanalaußenöffnungen in Richtung der Schwerkraft unterhalb der Membran angeordnet sind, so daß eingetretenes Spritzwasser unter Wirkung der Schwerkraft zu den Kanalaußenöffnungen geführt wird.

Weitere Merkmale, Vorteile und Einzelheiten der Erfindung ergeben sich aus der nachfolgenden Beschreibung eines Ausführungsbeispiels anhand der Zeichnungen. Es zeigt
- Fig. 1: eine Explosionsdarstellung einer erfindungsgemäßen Belüftungseinrichtung,

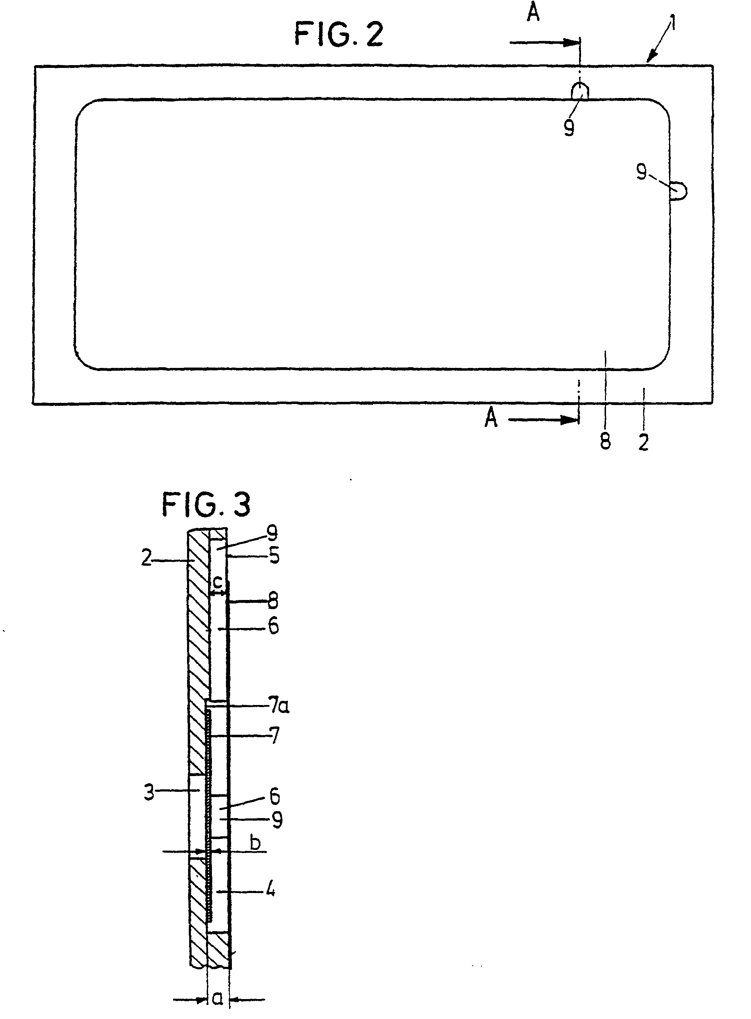

- Fig. 2: eine Draufsicht auf eine Belüftungseinrichtung gemäß Fig. 1,
- Fig. 3: eine Schnittdarstellung einer Belüftungseinrichtung gemäß Schnittlinie A-A nach Fig. 2.

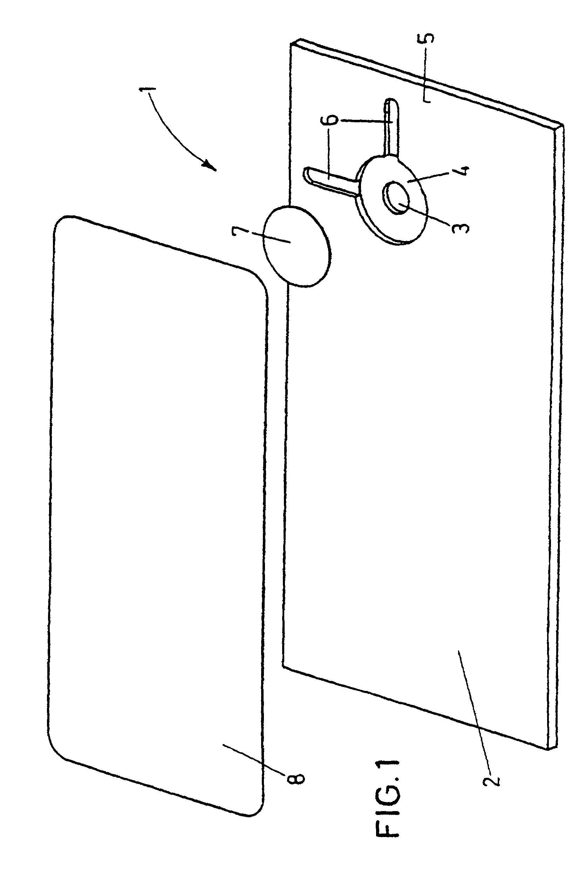

In Fig. 1 ist eine Belüftungseinrichtung 1 zum Belüften elektrischer Steuergeräte dargestellt. Die Belüftungseinrichtung 1 ist in einer Gehäusewand 2 des Gehäuses eines elektrischen Steuergerätes vorgesehen.

Die Belüftungseinrichtung 1 dient der Be- und Entlüftung des Gehäuseinnenraums. In dem Gehäuseinnenraum entstehen durch Temperaturschwankungen Druckunterschiede relativ zur Umgebung des Gehäuses, die durch die Belüftungseinrichtung 1 ausgeglichen werden. Des weiteren werden Wasserdampf und Öldämpfe aus dem Gehäuseinnenraum nach außen abgeführt.

In der Gehäusewand 2 ist eine Innenöffnung 3 vorgesehen, die die Gehäusewand 2 zum Innenraum des Gehäuses öffnet. Die Innenöffnung 3 kann als Bohrung ausgebildet sein oder bereits bei der Herstellung des Gehäuses geformt worden sein.

Die Innenöffnung 3 umgebend ist eine Vertiefung 4 angeordnet, die in der Außenfläche 5 der Gehäusewand 2 vorgesehen ist. Die Vertiefung 4 und die Innenöffnung 3 stehen miteinander in Verbindung und sind beide mit runder Kontur und konzentrisch zueinander vorgesehen. An die Vertiefung 4 angrenzend sind zwei Belüftungskanäle 6 vorgesehen, die sich als Ausnehmungen in der Außenfläche 5 von der Vertiefung 4 im wesentlichen radial zur Innenöffnung 3 und senkrecht zueinander nach außen erstrecken.

Die Vertiefung 4 nimmt eine Membran 7 auf. Die Membran 7 ist mit der Grundfläche 7a der Vertiefung 4 durch Klebstoff oder ein doppelseitiges Klebeband verbunden. Die Membran 7 bedeckt die Innenöffnung 3 und ist in diesem Bereich gasdurchlässig und deshalb dort nicht mit einer Selbstklebeschicht oder Klebstoff versehen.

Die gasdurchlässige Membran 7 ist darüber hinaus hydrophob, d. h. wasserabweisend. Als Trägermaterial für Membran 7 wird ein Polyestervlies verwendet. Dieses ist mit einem Polyethersulphonpolymer beschichtet, um es wasserabweisend zu machen. Darüber hinaus kann die Membran 7 auch noch mit oliophoben Eigenschaften ausgestattet sein.

Zur Fertigung der Membran 7 wird ein Polysulphonpolymer mittels einer entsprechenden Membranstraße kontinuierlich auf ein Polyestervlies aufgetragen. Im fortlaufenden Prozeß der Polymerisation verbindet sich das Polysulphon unlösbar mit dem Trägermaterial zu einer homogenen Einheit.

Typische Membranen weisen einen Luftdurchsatz im Mittel von 400 ml/min/cm² bei einem Differenzdruck von 70 mbar auf, wobei der Wassereintrittspunkt bei mehr als 1 bar liegt. Als Wassereintrittspunkt wird hier der Relativdruck zwischen Gehäuseinnenraum und Umgebung verstanden, der erforderlich ist, damit Wasser die Membran 7 durchdringen kann. Die größten Unterdruckwerte, die typischerweise im Innenraum von Gehäusen vorliegen, betragen ungefähr 250 mbar. Insofern ist ein Wassereintrittspunkt von größer 1 bar ausreichend um sicherzustellen, daß kein Wasser in den Gehäuseinnenraum eintritt.

Selbstverständlich eigenen sich auch andere Membranen mit geeigneten Gasdurchlässigkeitseigenschaften zur Verwendung in einer erfindungsgemäßen Belüftungseinrichtung.

Wenn die Tiefe der Vertiefung 4 gemessen von der Außenfläche 5 mit a bezeichnet wird und die Dicke der Membran 7 mit b bezeichnet wird, so ist b < a, d. h., wenn die Membran 7 in die Vertiefung 4 eingeklebt ist, bleibt oberhalb der Membran 7 ein freier Raum bis zur Außenfläche 5. Die Tiefe c der Belüftungskanäle 6 gemessen von der Außenfläche 5 ist so gewählt, daß sie der Tiefe des oberhalb der Membran 7 befindlichen freien Raums entspricht, d. h., daß c ungefähr so groß wie a minus b ist.

Auf der Außenseite weist die Belüftungseinrichtung 1 eine Abdecklage 8 auf, die mit der Gehäusewand 2 flächig verbunden wird. Die Abdecklage 8 bedeckt die Innenöffnung 3, die Vertiefung 4 und teilweise die Belüftungskanäle 6. Nicht überdeckt werden die der Vertiefung 4 abgewandten Enden der Belüftungskanäle 6, die die Kanalaußenöffnungen 9 bilden.

Als Abdecklage 8 wird in der Regel ein Aufkleber, insbesondere Firmenaufkleber, verwendet, der auf die Gehäusewand 2 geklebt wird. Der Aufkleber ist in der Regel selbstklebend, so daß sein Anbringen auf der Gehäusewand 2 problemlos erfolgen kann.

Zur Entlüftung des Gehäuseinnenraums treten Luft und/oder Wasserdampf und/oder Öldämpfe durch die Innenöffnung 3 hindurch, durchdringen die Membran 7 und werden über die Vertiefung 4 und die Belüftungskanäle 6 zu den Kanalaußenöffnungen 9 geführt. Für den Fall der Belüftung tritt Luft aus der Umgebung des Gehäuses durch die Kanalaußenöffnung 9 ein und wird über die Belüftungskanäle 6, die Vertiefung 4 zur Membran 7 geleitet. Diese ist primär für Gase, nicht jedoch für Flüssigkeiten permeabel. Gase gelangen durch die Membran 7 und die Innenöffnung 3 in den Innenraum des Gehäuses. Auf diese Weise wird vor allem ein Unterdruck im Gehäuse ausgeglichen, der durch Temperaturschwankungen entstanden sein kann. Spritzwasser, das von außen auf die Gehäusewand 2 oder Abdecklage 8 gerät, wird von dieser abgehalten. Durch die Kanalaußenöffnungen 9 gelangt nur sehr wenig Spritzwasser bis in die Vertiefung 4, da die Richtung des typischerweise auftreffenden Spritzwassers, d. h. im wesentlichen senkrecht zur Gehäusewand 2, verschieden ist von der Transportrichtung der Belüftungskanäle 6, d. h. im wesentlichen parallel zur Gehäusewand 2. Sollte Spritzwasser nichtsdestotrotz bis zur Membran 7 gelangen, so verhindert diese den Eintritt der Flüssigkeit in den Gehäuseinnenraum.

Belüftungseinrichtungen 1 der oben beschriebenen Art können bei elektrischen Geräten, vor allem Steuergeräten im Kraftfahrzeugbereich, zum Einsatz kommen. Vorteilhaft ist der Einsatz bei Geräten mit Aufklebern, Typenschildern oder Druckträgern, da letzere die Abdecklage 8 bilden und somit sowohl die Bescnilderung des Geräts, als auch die Bedeckung der Belüftungseinrichtung 1 durch ein und dieselbe Abdecklage 8 geschieht.
Es ist möglich, die Belüftungseinrichtung 1 je nach Aufbau und Einsatz des Geräts an verschiedenen Orten des Gehäuses, z. B. an der Unterseite oder den Seitenflächen, vorzusehen. Sinnvoll ist auch das Vorsehen einer Belüftungseinrichtung 1 in einer erhöhten Lage mit schräg nach unten in Richtung der Schwerkraft verlaufenden Belüftungskanälen 6. Auf diese Weise kann z. B. durch Wind eintretendes Spritzwasser in Folge der Schwerkraft abgeführt werden, was den Trocknungsprozeß der Membran 7 beschleunigt und die Wahrscheinlichkeit für das Eintreten von Wasser in den Gehäuseinnenraum reduziert.

Die Werkstoffe zur Ausbildung einer Belüftungseinrichtung 1, d. h. aus denen die Gehäusewand 2 gebildet ist, können beliebig gewählt werden. Vorzugsweise werden Polymere verwendet, so daß bei der Herstellung des Gehäuses die Innenöffnung 3, die Vertiefung 4 und die Belüftungskanäle 6 mit ausgeformt werden.

Bevorzugtes Einsatzgebiet einer erfindungsgemäßen Belüftungseinrichtung 1 ist der Kraftfahrzeugbereich.

### Bezugszeichen zu GR 97 P 2980 (97E1639):

- 1: Belüftungseinrichtung
- 2: Gehäusewand
- 3: Innenöffnung
- 4: Vertiefung
- 5: Außenfläche
- 6: Belüftungskanäle
- 7a: Grundfläche
- 7: Membran
- 8: Abdecklage
- 9: Kanalaußenöffnungen

## Patentansprüche

1. Belüftungseinrichtung (1), insbesondere für elektrische Steuergeräte, die in einer Gehäusewandung (2, 8) eines Gehäuses vorgesehen ist, umfassend
a) mindestens eine zum Innenraum des Gehäuses offene Innenöffnung (3) zur Aufnahme und Abgabe eines Gases von dem bzw. an den Innenraum des Gehäuses;
b) mindestens eine zur Umgebung des Gehäuses offene Außenöffnung (9) zur Aufnahme und Abgabe eines Gases von der bzw. an die Umgebung des Gehäuses, und
c) einen Belüftungskanal, durch den die Innenöffnung (3) und die Außenöffnung (9) zur Führung des Gases zwischen diesen miteinander verbunden sind, und in dem eine Membraneinheit angeordnet ist, **dadurch gekennzeichnet, daß**
d) die Innenöffnung (3) und die Außenöffnung (9) in der Gehäusewandung (2) vorgesehen sind und daß sie derart seitlich zueinander versetzt sind, daß sie einander nicht überlappen.

2. Belüftungseinrichtung gemäß Anspruch 1, **dadurch gekennzeichnet**, daß die Gehäusewandung (2, 8) eine Gehäusewand (2) und eine damit flächig verbundene Abdecklage (8) umfaßt.

3. Belüftungseinrichtung gemäß Anspruch 2, **dadurch gekennzeichnet**, daß die Belüftungskanaleinheit umfaßt
- eine die Innenöffnung (3) umgebende Vertiefung (4) in der Gehäusewand (2) und
- mindestens einen Belüftungskanal (6), der als Ausnehmung der Gehäusewand (2) ausgebildet ist, und sich von der Vertiefung (4) aus von dieser weg erstreckt.

4. Belüftungseinrichtung gemäß Anspruch 3, **dadurch gekennzeichnet**, daß die Abdecklage (8), die Innenöffnung (3), die Ausnehmung (4) und jeden Belüftungskanal (6) mit Ausnahme der Enden jeder Belüftungskanäle (6) bedeckt.

5. Belüftungseinrichtung gemäß Anspruch 4, **dadurch gekennzeichnet,** daß jede Kanalaußenöffnung (9) gebildet wird durch die der Vertiefung (4) abgewandten Enden jedes Belüftungskanals (9), die nicht durch die Abdecklage (8) bedeckt sind.

6. Belüftungseinrichtung gemäß Ansprüchen 1 bis 5, **dadurch gekennzeichnet**, daß die Membraneinheit eine Membran (7) aufweist, die gasdurchlässig sowie hydrophob und/oder oliophob ist.

7. Belüftungseinrichtung gemäß Ansprüchen 2 bis 6, **dadurch gekennzeichnet,** daß die Abdecklage (8) ein Firmenschild und/oder Typenschild und/oder Druckträger ist.

8. Belüftungseinrichtung gemäß Anspruch 5, **dadurch gekennzeichnet**, daß die Kanalaußenöffnungen (9) auf einem niedrigeren Niveau als die Membraneinheit angeordnet sind.

9. Belüftungseinrichtung gemäß Anspruch 3 bis 8, **dadurch gekennzeichnet**, daß mindestens zwei Belüftungskanäle (6) vorgesehen sind, die sich im wesentlichen radial von der Innenöffnung (3) und im wesentlichen senkrecht zueinander nach außen erstrecken.

10. Belüftungseinrichtung gemäß Anspruch 3, **dadurch gekennzeichnet**, daß die Membraneinheit mit einer Grundfläche (7a) der Vertiefung (4) verklebt ist.

## Claims

1. Ventilation device (1), especially for electrical control devices, which is provided in a housing walling (2, 8) of a housing, comprising
a) at least one inner opening (3), which is open with respect to the space inside the housing and is intended for receiving and delivering a gas from and to the space inside the housing;
b) at least one outer opening (9), which is open with respect to the surroundings of the housing and is intended for receiving and delivering a gas from and to the surroundings of the housing, and
c) a ventilation duct, through which the inner opening (3) and the outer opening (9) are connected to each other for leading the gas between them, and in which a membrane unit is arranged, characterized in that
d) the inner opening (3) and the outer opening (9) are provided in the housing walling (2) and in that they are offset laterally with respect to each other in such a way that they do not overlap each other.

2. Ventilation device according to Claim 1, characterized in that the housing walling (2, 8) comprises a housing wall (2) and a covering layer (8) bonded in surface-area contact with it.

3. Ventilation device according to Claim 2, characterized in that the ventilation duct unit comprises
- a depression (4) in the housing wall (2), surrounding the inner opening (3), and
- at least one ventilation duct (6) which is formed as a recess in the housing wall (2) and extends from the depression (4) away from the latter.

4. Ventilation device according to Claim 3, characterized in that the covering layer (8) covers the inner opening (3), the recess (4) and each ventilation duct (6) with the exception of the ends of each ventilation duct (6).

5. Ventilation device according to Claim 4, characterized in that each outer duct opening (9) is formed by the ends of each ventilation duct (6) which are remote from the depression (4) and are not covered by the covering layer (8).

6. Ventilation device according to Claims 1 to 5, characterized in that the membrane unit has a membrane (7) which is gas-permeable as well as hydrophobic and/or oliophobic.

7. Ventilation device according to Claims 2 to 6, characterized in that the covering layer (8) is a company plate and/or type identification plate and/or print carrier.

8. Ventilation device according to Claim 5, characterized in that the outer duct openings (9) are arranged on a lower level than the membrane unit.

9. Ventilation device according to Claims 3 to 8, characterized in that at least two ventilation ducts (6) are provided, which extend outward, essentially radially from the inner opening (3) and essentially perpendicularly to each other.

10. Ventilation device according to Claim 3, characterized in that the membrane unit is adhesively bonded to a base surface (7a) of the depression (4).

## Revendications

1. Dispositif (1) de ventilation, notamment pour des appareils de commande électriques, qui est prévu dans une cloison (2, 8) de boîtier d'un boîtier, comportant
a) au moins une ouverture (3) intérieure ouverte vers l'intérieur du boîtier pour recevoir un gaz venant de l'intérieur du boîtier ou évacuer un gaz sur l'intérieur du boîtier ;
b) au moins une ouverture (9) extérieure ouverte vers l'extérieur du boîtier pour recevoir un gaz venant du boîtier ou évacuer un gaz à l'extérieur du boîtier, et
c) un canal de ventilation par lequel l'ouverture (3) intérieure et l'ouverture (9) extérieure communiquent l'une avec l'autre pour le passage de ce gaz entre elles, et dans lequel est disposée une unité de membrane, caractérisé en ce que
d) l'ouverture (3) intérieure et l'ouverture (9) extérieure sont ménagées dans la cloison (2) du boîtier et en ce qu'elles sont décalées latéralement l'une par rapport à l'autre de telle manière qu'elles ne se chevauchent pas.

2. Dispositif de ventilation suivant la revendication 1, caractérisé en ce que la cloison (2, 8) du boîtier comporte une paroi (2) de boîtier et une couche (8) de recouvrement qui y est reliée en nappe.

3. Dispositif de ventilation suivant la revendication 2, caractérisé en ce que l'unité de canal de ventilation comprend
- un renfoncement (4) entourant l'ouverture (3) intérieure ménagée dans la paroi (2) du boîtier et
- au moins un canal (6) de ventilation qui est réalisé en évidement de la paroi (2) du boîtier et qui s'étend à partir du renfoncement (4) en s'en éloignant.

4. Dispositif de ventilation suivant la revendication 3, caractérisé en ce que la couche (8) de recouvrement recouvre l'ouverture (3) intérieure, l'évidement (4) et chaque canal (6) de ventilation à l'extrémité des extrémités de chaque canal (6) de ventilation.

5. Dispositif de ventilation suivant la revendication 4, caractérisé en ce que chaque ouverture (9) extérieure de canal est formée par les extrémités de chaque canal (9) de ventilation éloignées du renfoncement (4), qui ne sont pas recouvertes par la couche (6) de recouvrement.

6. Dispositif de ventilation suivant les revendications 1 à 5, caractérisé en ce que l'unité de membrane comporte une membrane (7) qui est perméable aux gaz ainsi que hydrophobe et/ou oliophobe.

7. Dispositif de ventilation suivant les revendications 2 à 6, caractérisé en ce que la couche (8) de recouvrement est une plaque de société et/ou une plaque signalétique et/ou un porte-plaque.

8. Dispositif de ventilation suivant la revendication 5, caractérisé en ce que les ouvertures (9) extérieures de canal sont ménagées à un niveau inférieur à celui de l'unité de membrane.

9. Dispositif de ventilation suivant la revendication 3 à 8, caractérisé en ce qu'il est prévu au moins deux canaux (6) de ventilation, qui s'étendent sensiblement radialement à partir de l'ouverture (3) intérieure et sensiblement perpendiculairement l'un à l'autre vers l'extérieur.

10. Dispositif de ventilation suivant la revendication 3, caractérisé en ce que l'unité de membrane est collée à une surface (7a) de fond du renfoncement (4).
